# EUROPÄISCHE PATENTSCHRIFT

(11) **EP 1 132 741 B1**
(45) Veröffentlichungstag und Bekanntmachung des Hinweises auf die Patenterteilung: **16.04.2008**
(21) Anmeldenummer: 01200757.1
(22) Anmeldetag: 28.02.2001
(51) Int. Cl.: G01P 3/487

(54) **Auswerteschaltung für einen magnetoresistiven Sensor**
Evaluation circuit for a magnetoresistive sensor
Circuit d'évaluation pour un capteur magnétorésistif

(30) Priorität: 02.03.2000 DE 10010370
(43) Veröffentlichungstag der Anmeldung: 12.09.2001
(73) Patentinhaber: NXP B.V., 5656 AG Eindhoven (NL)
(72) Erfinder: Muth, Michael, 52064 Aachen (DE)
(74) Vertreter: van der Veer, Johannis Leendert

(56) Entgegenhaltungen:
- EP-A- 0 611 952
- US-A- 5 231 351

## Beschreibung

Die Erfindung betrifft eine Auswerteschaltung zur Auswertung eines Ausgangssignals eines magnetoresistiven Sensors zur Drehzahlmessung, wobei die Auswerteschaltung eine Offsetkompensation des Sensorsignals vornimmt und einen Komparator aufweist, dem das offsetkompensierte Sensorsignal zugeführt wird und der dieses mir einer Referenzspannung vergleicht.

Derartige Auswerteschaltungen werden beispielsweise von der Firma Philips vertrieben. Sie dienen dazu, in Antiblockiersystemen für Kraftfahrzeuge die Ausgangssignale von magnetoresistiven Sensoren zu verarbeiten. Diese Sensoren liefern Signale, welche von der Drehzahl der Räder des Fahrzeugs abhängig sind. Sie weisen eine Offsetkompensation auf, die dazu dient, den Gleichspannungsanteil in dem, gegebenenfalls verstärkten, Ausgangssignal des Sensors zu beseitigen. Das offsetkompensierte Signal wird mittels eines Komparators verarbeitet, der im wesentlichen dafür sorgt, dass Störsignale beseitigt werden. Der Komparator vergleicht dazu das offsetkompensierte Sensorsignal mit einer Referenzspannung. Derartige Auswerteschaltungen sind aus EP 0 611 952 und US 5 231 351 bekannt.

Nach dem Einschalten einer derartigen Anordnung tritt das Problem auf, dass weder die Temperatur noch der Abstand zwischen Sensor und der magnetisierten Scheibe, deren Drehzahl mittels des Sensors gemessen wird, bekannt sind. Es ist daher auch nicht bekannt, welche Amplitude das Sensorsignal aufweist. Es besteht daher die Gefahr, dass beispielsweise bei noch stehendem Fahrzeug eine Störmodulation, die im Ausgangssignal des Sensors auftritt, als Sensorsignal interpretiert wird und sowohl die Offsetkompensation wie auch die Einstellung der Referenzspannung anhand dieser Störmodulation vorgenommen wird. Es würde dann bereits ein Regelbetrieb erfolgen, obwohl das Fahrzeug sich nicht bewegt. Dies ist unzulässig.

Es ist Aufgabe der Erfindung, die eingangs genannte Anordnung dahingehend weiterzuentwickeln, dass sie sich nach dem Einschalten zuverlässig nur auf tatsächliche Sensorausgangssignale und nicht auf etwaige Störsignale einstellt.

Diese Aufgabe ist erfindungsgemäß dadurch gelöst, dass in einem Initialmodus die Größe der Referenzspannung temperaturabhängig gewählt wird, wobei die Temperaturabhängigkeit an diejenige des Sensorsignals angenähert ist,
dass eine Steuerung vorgesehen ist, die in dem Initialmodus nacheinander
- prüft, ob ein Sensorsignal vorliegt,
- erst nach Vorliegen dieses Signals die Offsetkompensation auslöst,
- nachfolgend prüft, ob der Komparator ein Ausgangssignal liefert und
- erst nach Vorliegen dieses Signals in einen Regelmodus umschaltet, in welchem die Temperaturabhängigkeit der Referenzspannung abgeschaltet wird und in dem stattdessen die Referenzspannung auf etwa 40% der Maximalamplitude des offsetkompensierten Sensorsignals eingestellt wird.

Der Erfindung liegt die Erkenntnis zugrunde, dass das oben beschriebene Problem darin begründet liegt, dass einer in der Anordnung vorgesehenen Steuerung nicht bekannt ist, welche Temperatur seitens des Sensors vorliegt. Dessen Ausgangssignal ist nämlich stark temperaturabhängig, d.h. die Amplitude nimmt mit steigender Temperatur deutlich ab. Wird nun die Anordnung eingeschaltet und versucht ein Sensorsignal auszuwerten, so ist der Steuerung nicht bekannt, welche Temperatur herrscht. Dieses Problem wird noch dadurch verschärft, dass der Abstand zwischen dem Sensor und einem Sensorrad, das der Sensor magnetisch abtastet, ebenfalls nicht bekannt ist, dass dieser Abstand aber ebenfalls stark in die Amplitude des Sensorausgangssignals eingeht. Aus dieser Gesamtproblematik ergibt sich, dass die Ausgangsamplitude des Sensors sehr unterschiedlich sein kann, gleichzeitig aber die Ursache (Temperatur oder Abstand) nach dem Einschalten nicht bekannt ist. Es besteht daher die Gefahr, dass die Auswerteschaltung sowohl die Offsetkompensation wie auch die Einstellung der Referenzspannung, mit der der Komparator arbeitet, anhand eines Modulationssignals vornimmt, welches eine kleine Amplitude aufweist und welches tatsächlich ein Störsignal ist. Dies kann beispielsweise auch beim Stand des Fahrzeugs durch leichte Vibrationen des Sensorrades ausgelöst werden, die insbesondere durch diese Motoren verursacht werden können.

Die erfindungsgemäße Anordnung vermeidet dies dadurch, dass sie in geordneter Weise von einem Initialmodus in einen Regelmodus übergeht.

Die Referenzspannung ist so gewählt, dass sie ebenfalls temperaturabhängig ist. Die Art und Größe der Temperaturabhängigkeit ist dabei ähnlich gewählt wie diejenige des Sensors. Somit verhalten bei sich verändernder Temperatur die Größe der Referenzspannung und die Amplitude des Sensorausgangssignals sich etwa proportional zueinander.

Diese Eigenschaft wird im folgenden durch eine Steuerung ausgenutzt, die in einem Initialmodus zunächst prüft, ob ein Sensorsignal vorliegt. Dazu wird nicht das Ausgangssignal des Komparators, sondern ein gegebenenfalls verstärktes und gegebenenfalls analog/digital gewandeltes Ausgangssignal des Sensors geprüft. Erst wenn ein solches Sensorsignal vorliegt, beginnt die Steuerung die Offsetkompensation durchzuführen. Dabei wird ein gegebenenfalls in dem Ausgangssignal des Sensors vorliegender Gleichspannungsanteil beseitigt. Hat eine Einstellung dieser Offsetkompensation stattgefunden, wird nachfolgend geprüft, ob der Komparator ein Ausgangssignal liefert. Diese Prüfung ist wichtig, da der Komparator aufgrund der temperaturabhängigen Wahl der Referenzspannung erst dann ein Ausgangssignal liefert, wenn das Ausgangssignal des Sensors tatsächlich in Abhängigkeit der Temperatur so groß ist, dass es sich mit Sicherheit um ein Sensorsignal und nicht um eine Störmodulation handelt. Dies wird infolge der Temperaturabhängigkeit der Referenzspannung erreicht, die sich in ihrer Größe in Abhängigkeit der Temperatur auf die zu erwartende Amplitude des Sensorsignals einstellt. Erst wenn der Komparator ein Ausgangssignal liefert, kann davon ausgegangen werden, dass es sich um ein reguläres Sensorsignal handelt. Die Steuerung geht dann in einen Regelmodus über, in welchem die Referenzspannung nicht mehr temperaturabhängig gewählt wird, sondern in welchem die Referenzspannung auf etwa 40 % der Maximalamplitude des offsetkompensierten Steuersignals eingestellt wird. Es findet nun also eine unmittelbare Ankopplung der Größe der Referenzspannung an die tatsächliche Amplitude des Sensorsignals statt.

Im Ergebnis ist mittels dieser erfindungsgemäßen Anordnung erreicht, dass durch die Temperaturabhängigkeit der Referenzspannung und die Auswertung des Ausgangssignals des Komparators der Steuerung eine Information darüber vorliegt, ob bei gegebener Temperatur ein tatsächliches Sensorsignal vorliegt. Dies wird dadurch erzielt, dass der Komparator nur dann ein Ausgangssignal liefert, wenn der Sensor seinerseits tatsächlich ein Ausgangssignal liefert.

Es wird durch diese erfindungsgemäße Anordnung vermieden, einen gesonderten Temperatursensor vorzusehen, der zusätzliche Kosten und zusätzlichen Aufwand verursachen würde.

Es ist vorteilhaft, dass, wie gemäß einer Ausgestaltung der Erfindung nach Anspruch 2 vorgesehen ist, die Anordnung den Initialmodus insbesondere nach dem Einschalten des Sensors und/oder der Auswerteschaltung auslöst, da gerade dann die tatsächliche Ursache für die Größe der Amplitude des Sensors zunächst nicht bekannt ist.

Die Auswertung des Ausgangssignals des Komparators, bei dem es sich grundsätzlich um ein analoges Signal handelt, kann, wie gemäß einer weiteren Ausgestaltung der Erfindung nach Anspruch 3 vorgesehen ist, digital ausgewertet werden. Das heißt, es kann im einfachsten Falle nur geprüft werden, ob ein solches Signal vorliegt oder nicht. Die Größe des Signals spielt dabei keine Rolle. Es kann also eine einfache Ja/Nein Entscheidung getroffen werden.

Die Temperaturabhängigkeit der Referenzspannung im Initialmodus kann relativ einfach durch eine Stromspiegelschaltung, die in der IC-technik bekannt ist, erzeugt werden, welche die gewünschte Spannungsänderung bei sich ändernder Temperatur liefert.

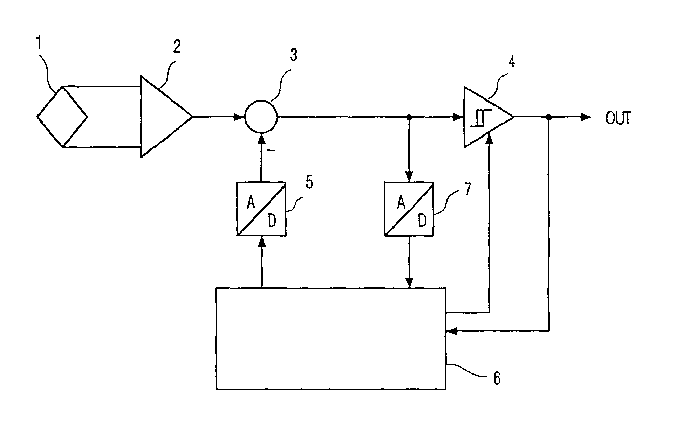

Nachfolgend wird ein Ausführungsbeispiel der Erfindung anhand der einzigen Figur der Zeichnung näher erläutert.

Die Zeichnung zeigt in Form eines Blockschaltbildes einen Sensor 1 und eine erfindungsgemäße Auswerteschaltung.

Ein in dem Blockschaltbild mit 1 gekennzeichneter Sensor ist beispielsweise ein magnetoresistiver Drehzahlsensor, der einem Antiblockiersystem in einem Fahrzeug, in dem der Sensor und die Auswerteschaltung eingebaut sind, Informationen über die Drehzahl eines nicht dargestellten Rades des Fahrzeugs bzw. eines mit diesem gekoppelten Sensorrades liefert. Dazu liefert der magnetoresistive Sensor 1, der in Form einer Widerstandsbrücke aufgebaut sein kann, zwei Ausgangssignale an einen Vorverstärker 2, dessen Ausgangssignal auf eine Überlagerungsstufe 3 geführt ist. Das Ausgangssignal der Überlagerungsstufe 3 gelangt an einen Komparator 4, der dieses Signal mit einem anderen Signal, das noch näher zu erläutern sein wird, vergleicht. Nur dann, wenn das Sensorsignal das Vergleichssignal bei positiver Amplitude überschreitet und bei negativer Amplitude unterschreitet, liefert der Komparator 4 ein Ausgangssignal, das in der Figur mit OUT gekennzeichnet ist und das als Sensorsignal ausgewertet werden kann und Informationen über die Drehzahl des Rades, das mittels des Sensors 1 abgetastet wird, liefert.

Bei einer derartigen Anordnung ergibt sich das Problem, dass einerseits eine Offsetkompensation vorgenommen werden muss und dass außerdem die Amplitude des Ausgangssignals des Sensors 1 bzw. des Vorverstärkers 2 stark temperaturabhängig ist. Außerdem ist diese Amplitude auch noch von dem Abstand des Sensors 1 zu einem Sensorrad, das nicht in der Figur dargestellt ist, abhängig.

Es ist daher eine Steuerung 6 vorgesehen, welche ein Ausgangssignal eines Analog/Digital-Umsetzers 7 auswertet, dem eingangsseitig das Ausgangssignal der Überlagerungsstufe 3 zugeführt wird. Der Steuerung 6 liegt also das Ausgangssignal der Überlagerungsstufe 3 in digitaler Form vor. Sie kann den Gleichanteil dieses Signals auswerten und kompensieren. Dies geschieht dadurch, dass der Gleichanteil in digitaler Form an einen Digital/Analog-Umsetzer 5 gegeben wird, und dieser in der Überlagerungsstufe 3 mit negativem Vorzeichen dem Ausgangssignal des Vorverstärkers 2 überlagert wird. Damit kompensieren sich in der Überlagerungsstufe 3 der tatsächliche Gleichanteil, wie er vom Vorverstärker 2 kommt, und das der Kompensation dienende Signal, das von dem Digital/Analog-Umsetzer 5 bzw. der Steuerung 6 kommt. Somit ist das Ausgangssignal der Überlagerungsstufe 3 von eventuellen Gleichanteilen befreit.

Das oben bereits angedeutete Problem, das sich insbesondere nach dem Einschalten der Auswerteschaltung bzw. des Sensors ergibt, wird durch die Steuerung 6 in folgender Weise beseitigt:
Nach dem Einschalten der Auswerteschaltung geht diese zunächst in einen Initialmodus. In dem Initialmodus prüft die Steuerung 6, ob ein Sensorsignal vorliegt, ob also der Analog/Digital-Umsetzer 7 ein Signal ungleich Null liefert. Ist dies der Fall, so führt die Steuerung in oben beschriebener Weise die Offsetkompensation durch. Damit wird zunächst der Gleichanteil in dem Ausgangssignal der Übertragungsstufe 3 beseitigt.

Nachfolgend prüft die Steuerung 6, ob der Komparator 4 ein Ausgangssignal liefert. Erst wenn dieses der Fall ist, erkennt die Steuerung 6 an der Existenz eines solchen Ausgangssignals des Komparators 4, dass der Sensor tatsächlich ein Ausgangssignal liefert und dass nicht etwa eine Störmodulation vorliegt.

Dieses ist dadurch möglich, dass der Komparator 4 in dem Initialmodus, in den er mittels der Steuerung 6 versetzt wird, das Ausgangssignal der Überlagerungsstufe 3 mit einer Referenzspannung vergleicht, welche nicht konstant ist, sondern welche temperaturabhängig gewählt ist. Dabei ist Art und Größe der Temperaturabhängigkeit der Referenzspannung ähnlich gewählt, wie Art und Größe der Abhängigkeit der Ausgangsspannung des Sensors 1 von der Temperatur.

Ist also aufgrund der vorliegenden Temperatur ein großes Ausgangssignal des Sensors 1 zu erwarten, so wird auch die Referenzspannung entsprechend erhöht. Ist insbesondere bei hoher Temperatur ein kleines Ausgangssignal des Sensors 1 zu erwarten, so wird die Referenzspannung entsprechend herunter gesetzt. Somit findet eine Anpassung der Referenzspannung an die vorliegende Temperatur und somit auch die zu erwartende Amplitude des Sensorsignals statt. Damit ist beispielsweise beim Einschalten der Anordnung und des Sensors gewährleistet, dass nicht etwa eine kleine Störmodulation, die deutlich niedriger ist als die zu erwartende Amplitude des Sensorsignals, tatsächlich als Sensorsignal gewertet wird und fälschlich eine Regelung anhand dieses Signals stattfindet.

Zu betonen ist, dass die Anpassung der Referenzspannung an die Temperatur in oben beschriebener Weise nur während des Initialmodus stattfindet. In dem Augenblick, in dem die Steuerung 6 ein Ausgangssignal des Komparators 4 erkennt, schaltet die Steuerung jedoch von dem Initialmodus in einen sogenannten Regelmodus. In diesem Regelmodus wird die Referenzspannung nicht mehr in Abhängigkeit der Temperatur gewählt, sondern wird in Abhängigkeit der Amplitude des Ausgangssignals des Sensors bzw. der Überlagerungsstufe 3 so eingestellt, dass sie etwa 40 % der Maximalamplitude des Sensorsignals beträgt. In diesem laufenden Betrieb findet dann also über die Amplitude des Sensorsignals eine laufende Anpassung an dessen Größe statt, die weiter wegen Temperaturabhängigkeiten und Ähnlichem schwanken kann.

Durch die Vorgehensweise der Steuerung 6 in dem Initialmodus wird jedoch das Problem behoben, das nach dem Einschalten auftritt, da der Steuerung 6 zunächst nicht bekannt ist, welche Temperatur vorliegt und somit auch nicht bekannt ist, welche Größenordnung die Amplitude des Sensorsignals aufweist. Dieses Problem wird durch die Temperaturabhängigkeit der dem Komparator 5 zugeführten Referenzspannung vermieden. Durch diese Temperaturabhängigkeit liefert der Komparator 4 nur dann ein Ausgangssignal, wenn tatsächlich ein Sensorsignal vorliegt. Diese Eigenschaft wiederum wird dazu genutzt, von dem Initialmodus in den normalen Regelmodus umzuschalten.

Somit löst die erfindungsgemäße Anordnung auf einfache Weise diese Problematik nach dem Einschalten, ohne dass dazu ein gesonderter Temperatursensor erforderlich wäre. Die Abhängigkeit der Referenzspannung von der Temperatur im Initialmodus kann beispielsweise mittels einer temperaturabhängigen Stromspiegelschaltung realisiert werden.

## Patentansprüche

1. Auswerteschaltung zur Auswertung eines Ausgangssignals eines magnetoresistiven Sensors (1) zur Drehzahlmessung, wobei die Auswerteschaltung eine Offsetkompensation des Sensorsignals vornimmt und einen Komparator (4) aufweist, dem das offsetkompensierte Sensorsignal zugeführt wird und der dieses mir einer Referenzspannung vergleicht,
**dadurch gekennzeichnet,**
**dass** eine Steuerung (6) vorgesehen ist, die derart ausgebildet ist, dass sie in einem Initialmodus die Größe der Referenzspannung temperaturabhängig wählt wobei die Temperaturabhängigkeit an diejenige des Sensorsignals angenähert ist,
- prüft, ob ein Sensorsignal vorliegt,
- erst nach Vorliegen dieses Signals die Offsetkompensation auslöst,
- nachfolgend prüft, ob der Komparator (4) ein Ausgangssignal liefert und
- erst nach Vorliegen dieses Signals in einen Regelmodus umschaltet, in welchem die Temperaturabhängigkeit der Referenzspannung abgeschaltet wird und in dem stattdessen die Referenzspannung auf etwa 40% der Maximalamplitude des offsetkompensierten Sensorsignals eingestellt wird.

2. Auswerteschaltung nach Anspruch 1,
**dadurch gekennzeichnet,**
**dass** die Steuerung (6) derart ausgebildet ist, dass sie den Initialmodus nach einem Einschalten des Sensors (1) und/oder der Auswerteschaltung auslöst.

3. Auswerteschaltung nach Anspruch 1,
**dadurch gekennzeichnet,**
**dass** der Steuerung (6) derart ausgebildet ist, dass sie das Ausgangssignal des Komparators (4) zugeführt wird, die dieses digital auswertet.

4. Auswerteschaltung nach Anspruch 1,
**dadurch gekennzeichnet,**
**dass** zur Erzeugung der temperaturabhängigen Referenzspannung eine Diodenkette vorgesehen ist.

5. Auswerteschaltung nach Anspruch 1,
**dadurch gekennzeichnet,**
**dass** der magnetoresisive Sensor (1) als Drehzahlsensor für ein Antiblockiersystem eines Fahrzeugs vorgesehen ist.

## Claims

1. An evaluation circuit for evaluating an output signal of a magnetoresistive sensor (1) for rotational speed measurement, in which the evaluation circuit performs an offset compensation of the sensor signal and comprises a comparator (4) which receives the offset-compensated sensor signal and compares it with a reference voltage, **characterized in that** a control unit (6) is provided which is arranged such that, in an initial mode, it selects the value of the reference voltage in dependence upon the temperature, the temperature dependence being approximated to that of the sensor signal,
- checks whether a sensor signal is present,
- triggers the offset compensation only after the presence of said signal,
- subsequently checks whether the comparator (4) supplies an output signal, and
- changes over to a control mode only after the presence of said signal, in which control mode the temperature dependence of the reference voltage is switched off and, instead, the reference voltage is adjusted to approximately 40% of the maximum amplitude of the offset-compensated sensor signal.

2. An evaluation circuit as claimed in claim 1, **characterized in that** the control unit (6) is arranged such that it triggers the initial mode after switching on the sensor (1) and/or the evaluation circuit.

3. An evaluation circuit as claimed in claim 1, **characterized in that** the control unit (6) is arranged such that it receives the output signal of the comparator (4) which digitally evaluates this output signal.

4. An evaluation circuit as claimed in claim 1, **characterized in that** a diode circuit is provided for generating the temperature-dependent reference voltage.

5. An evaluation circuit as claimed in claim 1, **characterized in that** the magnetoresistive sensor (1) is provided as a rotational speed sensor for an anti-blocking system of a vehicle.

## Revendications

1. Circuit d'évaluation destiné à évaluer un signal de sortie d'un capteur magnéto-résistant (1) pour la mesure du nombre de tours, le circuit d'évaluation effectuant une compensation de décalage du signal de capteur et comportant un comparateur (4) auquel est amené le signal de capteur compensé par décalage et qui compare celui-ci avec une tension de référence,
**caractérisé en ce qu'**
il est prévu une commande (6) qui est conçue de telle sorte qu'elle choisit, dans un mode initial, la grandeur de la tension de référence en fonction de la température, la dépendance à la température étant rapprochée de celle du signal de capteur, la commande :
- vérifie si un signal de capteur est présent,
- juste après la présence de ce signal, déclenche la compensation de décalage,
- vérifie ensuite si le comparateur (4) délivre un signal de sortie et
- juste après la présence de ce signal, permute dans un mode de régulation, dans lequel la dépendance à la température de la tension de référence est mise hors circuit et, à la place, la tension de référence est ajustée à environ 40 % de l'amplitude maximale du signal de capteur compensée par décalage.

2. Circuit d'évaluation selon la revendication 1,
**caractérisé en ce que**
la commande (6) est conçue de telle sorte qu'elle déclenche le mode initial après l'intervention du capteur (1) et/ou du circuit d'évaluation.

3. Circuit d'évaluation selon la revendication 1,
**caractérisé en ce que**
la commande (6) est conçue de telle sorte que le signal de sortie du comparateur (4) est amené à la commande (6), laquelle évalue celui-ci numériquement.

4. Circuit d'évaluation selon la revendication 1,
**caractérisé en ce que**
pour la génération de la tension de référence en fonction de la température, il est prévu une chaîne de diodes.

5. Circuit d'évaluation selon la revendication 1,
**caractérisé en ce que**
le capteur magnéto-résistant (1) est prévu sous la forme de capteur de nombre de tours pour un système antiblocage d'un véhicule.
